(19) Europäisches Patentamt / European Patent Office / Office européen des brevets

(11) **EP 2 383 798 A1**

(12) **EUROPEAN PATENT APPLICATION**
published in accordance with Art. 153(4) EPC

(43) Date of publication:
**02.11.2011 Bulletin 2011/44**

(51) Int Cl.:
*H01L 31/052* (2006.01)     *H01L 31/042* (2006.01)

(21) Application number: **10733444.3**

(86) International application number:
**PCT/JP2010/050484**

(22) Date of filing: **18.01.2010**

(87) International publication number:
**WO 2010/084837 (29.07.2010 Gazette 2010/30)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **23.01.2009 JP 2009013508**

(71) Applicant: **Toyota Jidosha Kabushiki Kaisha Toyota-shi, Aichi 471-8571 (JP)**

(72) Inventor: **SUGA, Yoshinori Toyota-shi Aichi 471-8571 (JP)**

(74) Representative: **Winter, Brandl, Fürniss, Hübner, Röss, Kaiser, Polte - Partnerschaft Alois-Steinecker-Strasse 22 85354 Freising (DE)**

(54) **SOLAR CELL MODULE**

(57)     A solar cell 1 according to the present invention includes a front panel 2, photovoltaic generating parts 3a located on a back side of the front panel 2 and arranged in an array direction at a designated pitch; and a reflective part 4 and 5 that reflects sunlight toward the back surface of the photovoltaic generating parts 3a. The reflective part includes a reflective panel 5 and a back panel 4. The reflective panel 5 includes peak portions projecting into a front direction of the photovoltaic generating parts and arranged at a cycle of a half pitch of the designated pitch P, and valley portions concaving into back side of the photovoltaic generating parts as viewed from a vertical direction vertical to the front direction and the array direction, wherein positions of centerlines B of the photovoltaic generating parts 3a in the array direction and positions of midlines A between the photovoltaic generating parts 3a next to each other in the array direction correspond to positions of the peak portions in the array direction, and wherein a first R machined portion 5a is formed at the peak portion corresponding to the midline A, and a first radius R1 which constitutes the first R machined portion 5a is greater than 0.05mm and smaller than one-fifth of the designated pitch P.

FIG.1

EP 2 383 798 A1

**Description**

## TECHNICAL FIELD

The present invention relates to a solar cell which utilizes sunlight effectively as an alternative energy source to oil and generates power.

## BACKGROUND ART

Recently, demands for reducing carbon dioxide which is considered as a main factor that induces global heating has been increasing. Therefore, it is suggested to research and develop solar cell technology which utilizes sunlight effectively and generates power as an alternative energy source to thermal power generation which utilizes oil and coal and a power source including an internal combustion engine. Solar cell technology utilizes sunlight as a power source which will not be depleted, and does not emit carbon dioxide. Thus, it is highly possible that solar cell technology will have a high degree of availability for various technological fields such as a satellite technology, a private electric generator technology, commercial power source technology or the like.

As for a general configuration of a solar cell as described above, the solar cell includes plate type cell string that are formed by sandwiching and sealing plural cells that are connected in series into resin or glass. The cells are made of poly crystal silicon or crystal silicon and are used for photovoltaic generation. In the cell string, the plural cells are arranged in the longitudinal direction and the lateral direction at almost even intervals. A front panel which is made of transparent resin, glass or the like is disposed in front of the cell string. Further, a transparent resin, a glass or the like that is disposed on the back of the plural cells and between the plural cells and the front panel constitutes a back panel. A reflector is disposed on the back of the back panel. The reflector concentrates sunlight into the plural cells. For example, patent documents 1 to 3 disclose such a reflector as described above which includes a bellows-like wave surface.

Patent Document 1: Japanese Laid-Open Patent Application No. 2001-119054
Patent Document 2: Japanese Laid-Open Patent Application No. H11-307791
Patent Document 3: Japanese Laid-Open Patent Application No. H11-074552

## SUMMARY OF INVENTION

## PROBLEM TO BE SOLVED BY THE INVENTION

The plural cells of the solar cell are arranged in parallel at almost even intervals in an array direction and the reflector is disposed on the back of the plural cells. Thus, the more the reflection ratio of the reflector is improved in order to improve the efficiency of the power, the more problems occur as discussed below. Since sunlight which enters the cells via the front panel is reflected in various directions by the reflector located on the back of the cells and becomes scattered light, the contrast between the black colored cells and the white silver colored reflector becomes even greater. Thus, an exterior appearance, beauty and design of the solar cell may be detracted. Since the solar cell is to be mounted on a prominent place such as a roof of a house or a vehicle, merchantability of the house or the vehicle on which the solar cell is mounted may be detracted.

Since sunlight enters the surface of the front panel of the solar cell at a very shallow angle in the morning and at night, it becomes difficult to guide the sunlight fully on the back of the plural cells. The more a photoelectric conversion efficiency of the solar cell is improved, the more the problem as described above may occur. Thus, power generation efficiency of the solar cell may be decreased. Since sunlight enters the surface of the front panel of the solar cell at a very shallow angle during all the daylight hours of winter, it becomes difficult to guide the sunlight fully on the back of the plural cells. Thus the more a photoelectric conversion efficiency of the solar cell is improved, the more problem occur as described above.

According to the conventional technique as described above, there is a problem that the solar cell is not suitable for reflecting sunlight more effectively in order to satisfy the improved power generation efficiency which is achieved by guiding the sunlight into the cells more effectively and to satisfy the merchantability which is achieved by reflecting the sunlight more properly.

Thus, it is an aspect of the present invention to provide a solar cell which can reflect sunlight more properly.

## MEANS FOR SOLVING THE PROBLEMS

According to one embodiment of the present invention, in order to achieve the object as described above, a solar cell includes a front panel, photovoltaic generating parts configured to be located on a back side of the front panel and to be arranged in an array direction at a designated pitch, and a reflective part configured to reflect sunlight toward the back surfaces of the photovoltaic generating parts. The reflective part includes a reflective panel and a back panel. The reflective panel includes peak portions projecting into a front direction of the photovoltaic generating parts arranged at a cycle of a half pitch of the designated pitch, and valley portions concaving into a back side of the photovoltaic generating parts as viewed from a vertical direction, vertical to the front direction and the array direction. Positions of centerlines of the photovoltaic generating parts in the array direction and positions of midlines between the photovoltaic generating parts next to each other in the array direction correspond to positions of the peak portions in the array direction. A first R machined portion is formed at the peak portion corresponding to the midline, and a first radius which constitutes the first R machined portion is greater than 0.05mm and smaller than one-fifth of the designated pitch.

Herein, it is preferable that the solar cell includes the front panel, a resin seal, plural cells that constitute the photovoltaic generating parts, a resin seal and the back panel which is included in the reflective part in this order in an incident direction, i.e. in a direction from the front side to the back side. Further, it is preferable that the solar cell includes a material which constitutes the reflective panel included in the reflective part after being laminated. The basic material is, for example, a reflective film which is made by Ag vapor deposition, an Al substrate with high reflectivity, a white formable resin film, etc.

The cell is of a bifacial type, and preferably has a bifaciality greater than 0.7. The bifaciality indicates a ratio of the generation efficiency of the front side to the generation efficiency of the back side of the cell. An R treatment is performed by chamfering a corner of a crista portion or a corner portion that is constituted by two planes having different normal lines, thereby forming a rounded surface that has a designated radius. (rounded with a radius of A mm) In the R treatment, appropriate machined process is utilized.

According to the solar cell of the present invention, since the peak portion includes the first R machined portion, and the first radius of the first R machined portion is greater than 0.05mm and is smaller than one-fifth of the pitch P, functional effects as described below are obtained in a case where sunlight enters the peak portion of the reflective panel that constitutes a rounded portion. It becomes possible to suppress multiple scattering at the peak portion and to improve merchantability of a house or a vehicle on which the solar cell is mounted by suppressing the glare in striped shape configuration and detraction of an exterior appearance. Return of the reflected light at the peak portion increases in a case where the first radius becomes greater than one-fifth of the pitch P. The scattering range of the reflected light becomes greater and thus bright lines in a striped shape configuration increases in a case where the first radius becomes less than 0.05mm. The present invention is made based on this knowledge.

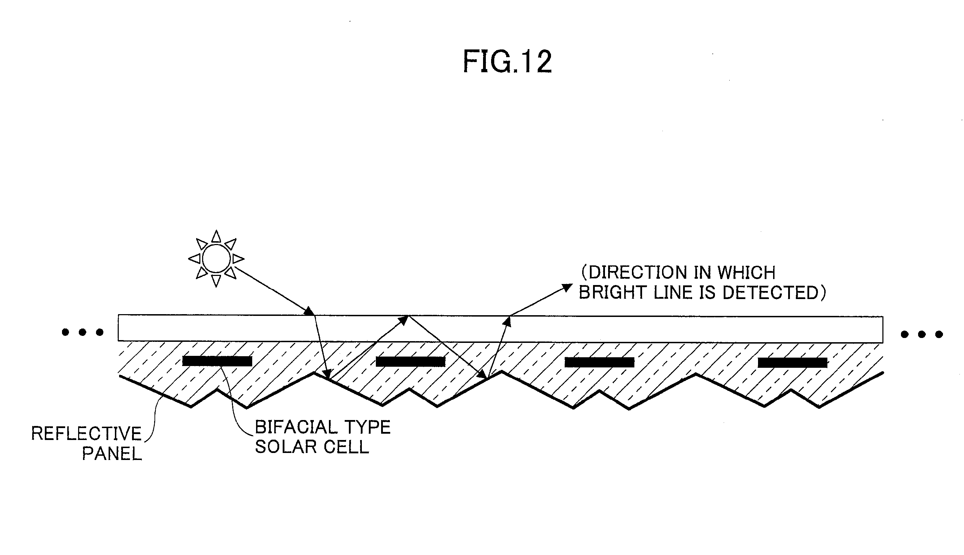

The reason why the first radius which constitutes the first R machined portion is greater than 0.05mm and is smaller than one-fifth of the pitch P will be described hereinafter. One of the reasons which causes a visually undesirable bright lines in a striped shape configuration to occur as viewed from the front surface is leakage of sunlight. Sunlight leaks from a module along a light path which is indicated by arrows shown in Fig. 12. This phenomenon tends to occur specifically in a case where a scale factor of light collection is improved in order to decrease the cost of the solar cell. There is a dilemma that the exterior appearance is detracted in a case where the solar cell becomes narrower in order to decrease the cost of the solar cell.

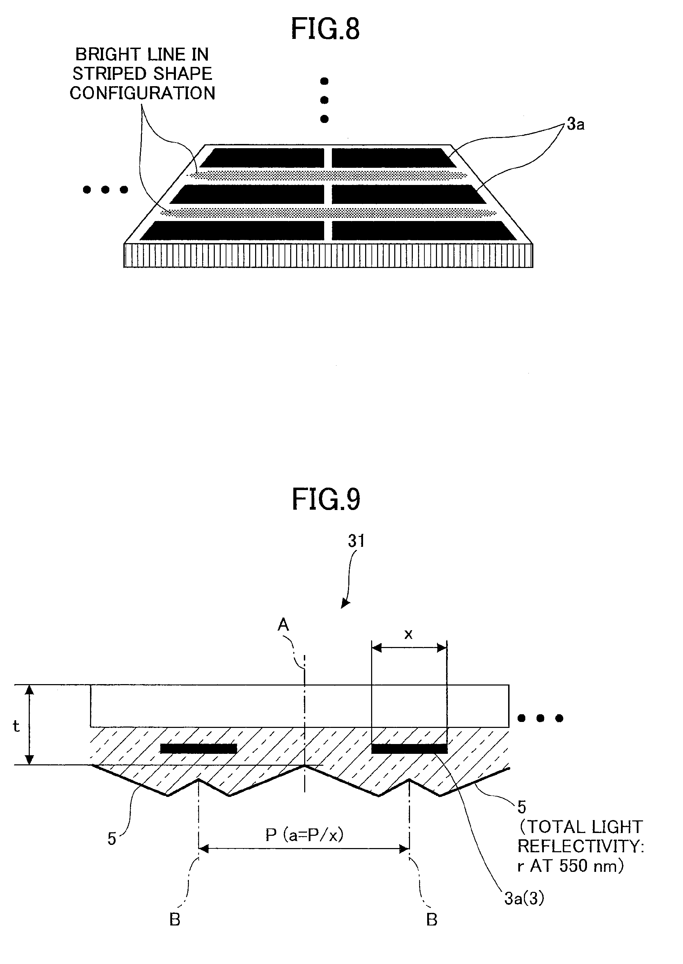

A condition for suppressing leakage of the sunlight along the light path as described above is to satisfy the relationship defined by formula 1 as described below. Herein, as shown in Fig. 9, the cells are disposed between a thickness t. A pitch at which the cells are arranged is P, a scale factor of light collection is a, incident angle of the sunlight which enters with inclined angle is s, a refraction index of a transparent materials included in the module is n, an inclined angle φ between the reflecting panel, i.e. the mirror, and the front panel or a plane which is constituted by the cell is φ.

[formula 1]

$$\frac{P}{2} - \frac{P}{2a} - t \cdot \tan\left(2\phi + \arcsin(\frac{\sin s}{n})\right) - \frac{t}{2\tan\left(90° - 2\phi - \arcsin(\frac{\sin s}{n})\right)} > 0$$

The left hand member of the formula 1 indicates a decreasing function of φ with respect to sunlight which enters from the inclined angle. In other words, in a case where the first radius of the first R machined portion becomes larger (an area in which φ remains small becomes larger), it becomes possible to suppress light loss which occurs in a mode as shown in Fig. 12 and causes the glare in a striped shape.

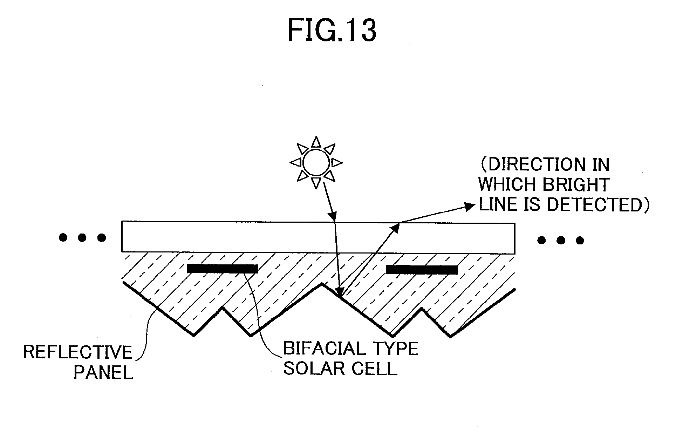

On the other hand, sunlight which is reflected by a portion, such as the first R machined portion, located far from the cell, enters the cell after being totally reflected by an internal front surface of the front panel. However, there is light flux which leaks from the module as shown in Fig. 13 and becomes loss light depending on the light path of the reflected light of which direction is changed by the reflective panel, i.e. the mirror. This could be a factor which detracts the exterior appearance in a mode different from the mode as described above. It is necessary for sunlight, which is reflected by the reflective panel, to satisfy a total reflection condition in order to suppress the detraction of the exterior appearance in this mode. Accordingly, it is necessary to satisfy the relationship of formula 2 as shown below.

[formula 2]

$$2\phi + \arcsin\left(\frac{\sin s}{n}\right) - \arcsin\frac{1}{n} > 0$$

The left hand member of the formula 2 indicates a increasing function of $\varphi$. In other words, in a case where the first radius of the first R machined portion becomes smaller (an area in which $\varphi$ remains small becomes smaller), it becomes possible to suppress light loss which occurs in the mode as shown in Fig. 13 and causes the glare.

As described above, the first radius of the first R machined portion has an optimal range. In a practical use, the first radius is determined based on a balance between the exterior appearance and an optical efficiency. Thus the first radius is not limited to a narrow range which is defined by formulas 1 and 2. Specifically, it is preferable to form the first radius at least greater than 0.05mm and smaller than one-fifth of the pitch P.

It becomes possible to suppress the occurrence of light loss which is caused by the leakage of sunlight that is not collected onto the back surfaces of the photovoltaic generating parts after being reflected by the reflective panel, in a case where sunlight enters the solar cell at a shallow angel with regard to the front panel. Accordingly, it becomes possible to improve the light collection performance and the power generation efficiency in a case where the sunlight enters the solar cell at a shallow angle.

The solar cell according to an embodiment of the present invention has an enhanced bifaciality, and a portion at which the thickness of the peak portion of the reflective panel and the back panel in the front direction becomes the thinnest is located at the centerline of the photovoltaic generating parts in the array direction. That is, the portion is located on the back side of the centerline. Thus, the following functional effects are obtained. When a person views the solar cell, the person sees a black exterior which is provided by a reflection of the back surface of the photovoltaic generating parts through the reflective panel. Thus, the glare of the solar cell is suppressed, and the exterior appearance of the solar cell is improved and has a premium look.

As described above, the first radius R1 of the first R machined portion 5a is more than 0.05mm and smaller than P/5 which corresponds to one-fifth of the pitch P. It is preferable that the first radius R1 of the first R machined portion 5a is more than 0.10mm and smaller than P/8 in order to improve the suppression of diffracted light and to optimize the exterior appearance as viewed from the front side. Further, it is preferable that the first radius R1 of the first R machined portion 5a is more than 0.15mm and smaller than P/15 in order to completely eliminate the glare caused by a diffraction phenomenon and to maintain the strength of the module.

Herein, according to the solar cell as described above, it is preferable that a midline-peak-valley-pitch between the peak portion corresponding to the midline and the valley portion next to the peak portion in the array direction is larger than a centerline-peak-valley-pitch between the peak portion corresponding to the centerline and the valley portion next to the peak portion in the array direction.

According to the solar cell as described above, the valley portion of the reflective plate is located in a position which is closer to the centerline than to a midpoint between the midline of the photovoltaic generating parts next to each other and the centerline of the photovoltaic generating parts in the array direction. Thus, it becomes possible to reflect the sunlight by a first reflective surface which is formed between the peak portion corresponding to the midline and the valley portion, in a case where the sunlight enters the solar cell at a shallow angle. Further, it becomes possible to reflect sunlight by a second reflective surface which is formed between the valley portion and the peak portion corresponding to the centerline, and to guide the sunlight which is reflected by a double reflection onto the back surface of the photovoltaic generating part appropriately and properly.

According to the solar cell as described above, it becomes possible to collect the sunlight effectively on the back surface of the photovoltaic generating part when the sunlight enters the solar cell at a shallow angle in the morning, at nightfall or in winter. Thus, it becomes possible to keep the enhanced light collection performance and enhanced power generation efficiency through out the day and during each of the four seasons. Further, it becomes possible to improve energy efficiency by improving an integral intensity of temporal transitional and seasonal transitional electric generating capacity.

As for the solar cell as described above, it becomes possible to suppress multiple scattering of sunlight at the peak portions in a case where the pitch, which is a gap between the photovoltaic generating parts, is increased. Thus, it becomes possible to suppress a leakage of the sunlight which is caused by the sunlight being reflected at the valley portions and not being guided onto the back surfaces of the photovoltaic generating parts. Accordingly, the light loss is suppressed, and a scale factor of light collection and a light collection performance are improved. A ratio of profile areas of the photovoltaic generating part to a profile area of the solar cell as viewed from the front side is reduced. Thus, it becomes possible to reduce cost of the solar cell.

As for the solar cell as described above, it is preferable that a second R machined portion is formed at the valley portion next to the peak portion corresponding to the centerline, and wherein a second radius which constitutes the second R machined portion is larger than the first radius.

According to the solar cell as described above, it becomes possible to suppress multiple scattering of light at the valley portions in a case where the incident sunlight reaches the valley portions. Further, it becomes possible to change the direction of the reflected sunlight to the back surface of the photovoltaic generating parts, effectively. When a person sees the solar cell from an angle, the solar cell can suppress the glare of the solar cell, and the exterior appearance of the solar cell is improved and has a premium look.

As for the solar cell as described above, it is preferable that a designated formula is defined by the pitch, an inclined angle between the reflective panel and the array direction as viewed from the vertical direction, a thickness between a front surface of the front panel and the peak portion of the reflective panel corresponding to the midline in the front direction, a scale factor of light collection derived by dividing the pitch by the width of the photovoltaic generating part in the array direction and a total light reflectivity of the reflective panel.

A lower limit of the inclined angle is derived by subtracting 15 degrees from the inclined angle corresponding to a maximum value of the designated formula when the inclined angle ranges between 0 to 90 degrees and an upper limit of the inclined angle is derived by adding 15 degrees to the inclined angle corresponding to the maximum value of the designated formula.

The inclined angle is greater than the lower limit and is smaller than the upper limit.

Hereinafter, a technique for deriving the designated formula and numerical limitation will be described. A light energy $I(z,\theta)$ shows a light energy of sunlight which enters a single cell of a bifacial type solar cell. The single cell constitutes a unit cell. The light energy $I(z,\theta)$ is shown as relational formula 3 where the solar cell is disposed so that angle of the solar cell is optimized at southing. Herein, z indicates an elevation angle of incident sunlight, and i(z) indicates incident light energy taking into account the Fresnel loss in a unitary area of the front panel. $\theta$ indicates a inclined angle of the reflective panel, P indicates the pitch between the cells, a indicates a scale factor of light collection and r indicates a reflection ratio of the reflective panel. The reflective panel constitutes a mirror for collecting light.

[formula 3]

$$I(z,\theta) = 2 \cdot i(z) \cdot \left[ \frac{P}{2a} + r \cdot \left\{ \frac{1}{2} \cdot \frac{a \cdot t \cdot \tan 2\theta + a \cdot P \cdot \tan 2\theta \cdot \sin \theta + P}{a \cdot (1 + \tan 2\theta \cdot \tan \theta)} - \frac{P}{2a} \right\} \right]$$

According to the formula 3, a total integral intensity $I_{tot}$ of the light energy which reaches the cell from the sun is derived by relational formula 4.

[formula 4]

$$I_{tot} = 2 \cdot \int_0^\pi i(z) \cdot \left\{ (1-r)\frac{P}{2a} + \frac{r}{2} \cdot \frac{a \cdot t \cdot \tan 2\theta + a \cdot P \cdot \tan 2\theta \cdot \sin \theta + P}{a \cdot (1 + \tan 2\theta \cdot \tan \theta)} \right\} dz$$

A total integral intensity $I_{noc}$ is derived from relational formula 5. A total integral intensity $I_{noc}$ shows the total light energy of a solar cell which does not include a reflective panel, i.e. an element for collecting light, under the same module dimension as formula 4.

[formula 5]

$$I_{noc} = P \cdot \int_0^\pi i(z) \cdot dz$$

Herein, $\Omega(\theta)$ indicates the optical efficiency. $\Omega(\theta)$ is derived by dividing $I_{tot}$ by $I_{noc}$, and is shown by formula 6.

[formula 6]

$$\Omega(\theta) = \frac{1-r}{a} + \frac{r}{P} \cdot \frac{a \cdot t \cdot \tan 2\theta + a \cdot P \cdot \tan 2\theta \cdot \sin\theta + P}{a \cdot (1 + \tan 2\theta \cdot \tan\theta)}$$

Formula 6 is used as the designated formula. A value φmax of the inclined angle θ at which the optical efficiency $\Omega(\theta)$ becomes the maximum is selected as the inclined angle φ of the reflective panel, i.e. the mirror for collecting light. Thus, it becomes possible to enhance the light collection efficiency to the highest value. In practical use, the inclined angle of the reflective panel, i.e. the mirror for collecting light, is determined by taking into account a limitation of a mounting angle or a mounting direction of the solar cell to a house or a vehicle, and a limitation of the external appearance. Therefore, the inclined angle φ of the reflective panel, i.e. the mirror for collecting light, of the present invention preferably satisfies a formula 7 as shown below, in a condition that the inclined angle θ=φmax is used as the standard. The inclined angle θ=φmax yields the maximum value Ωmax when the angle θ runs from 0 degree to 90 degrees.

[formula 7]

$$\Phi\max - 15° \leqq \Phi \leqq \Phi\max + 15°$$
$$(\text{PREFERABLE} \qquad \Phi\max - 10° \leqq \Phi \leqq \Phi\max + 10°$$
$$\text{MORE PREFERABLE} \quad \Phi\max - 7° \leqq \Phi \leqq \Phi\max + 7° \quad )$$

Herein, it is preferable to subtract or add 10 degrees instead of 15 degrees from the inclined angle. Further, it is more preferable to subtract or add 7 degrees instead of 15 degrees from the inclined angle. The total light reflectivity at a wavelength of 550nm of sunlight is used.
According to the solar cell as described above, the sunlight reflected by the reflective panel is guided uniformly onto the back surface of the photovoltaic generating part. Thus, unevenness in the strength of the sunlight on the back surface is reduced when the sunlight is exposed onto the back surface of the photovoltaic generating part. It becomes possible to suppress a decrease in power generation efficiency, which is caused by the unevenness in the strength of the sunlight, of the photovoltaic generating parts and the solar cell as a whole in advance.
Further, it becomes possible to efficiently utilize a total internal reflection light which is reflected under Snell's law at the surface of the front panel. The leakage of sunlight which is caused in a condition where sunlight is not collected onto the back surface of the photovoltaic generating part is suppressed regardless of directions in that the solar cell is mounted on a roof of a house, vehicle, etc. Thus, it becomes possible to keep the enhanced power generation efficiency through out the year.
Further, since the solar cell can reduce the unevenness in the strength of the sunlight on the back surface of the photovoltaic generating part, it becomes possible to suppress heat deterioration of the resin seal which is caused by enhanced light collection. Accordingly, it becomes possible to suppress the occurrence of the problems in the solar cell by suppressing occurrence of peel-off of the resin seal from the photovoltaic generating parts and crack therebetween. Thus, the life duration of the module which constitutes the solar cell is not shortened as compared to the conventional solar cell in which light collection is not realized.

**EFFECTS OF THE INVENTION**

In accordance with the present invention, a solar cell which can reflect sunlight more properly can be provided.

## BRIEF DESCRIPTION OF THE DRAWINGS

Fig. 1 shows a pattern diagram of a solar cell according to one embodiment of the present invention;
Fig. 2 shows a pattern diagram of a solar cell according to one embodiment of the present invention;
Fig. 3 shows a pattern diagram of a conventional solar cell;
Fig. 4 shows a pattern diagram of a solar cell according to one embodiment of the present invention;
Fig. 5 shows a pattern diagram of a solar cell according to one embodiment of the present invention;
Fig. 6 shows a pattern diagram of a solar cell according to one embodiment of the present invention;
Fig. 7 shows a function effect of the solar cell according to an embodiment of the present invention;
Fig. 8 shows another function effect of the solar cell according to one embodiment of the present invention;
Fig. 9 shows a pattern diagram of a solar cell according to one embodiment of the present invention;
Fig. 10 shows a pattern diagram of a solar cell according to one embodiment of the present invention;
Fig. 11 shows a table which includes results of external appearances of modules that constitute solar cells and power generation efficiencies;
Fig. 12 shows a pattern diagram of a conventional solar cell; and
Fig. 13 shows a pattern diagram of a conventional solar cell.

## BEST MODE FOR CARRYING OUT THE INVENTION

In the following, preferred embodiments of the present invention are described with reference to the drawings.

<First Embodiment>

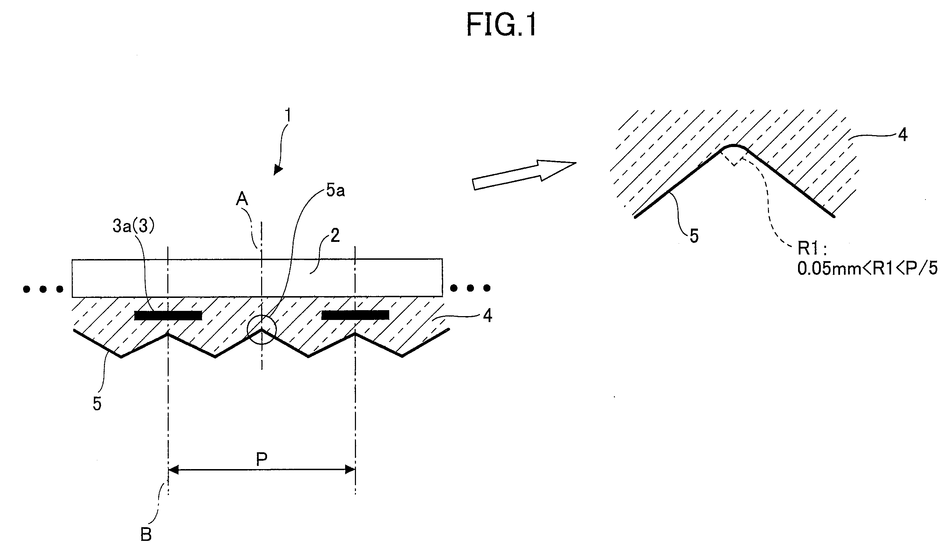

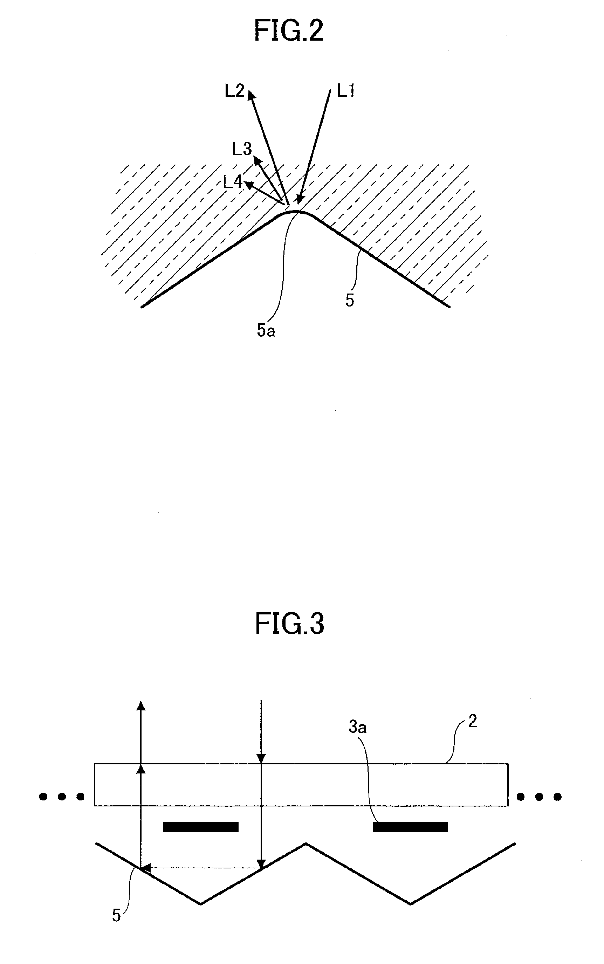

Fig. 1 shows a pattern a diagram of a solar cell according to one embodiment of the present invention. Fig. 2 shows a pattern diagram of a solar cell according to one embodiment of the present invention.

The solar cell shown in Fig. 1 includes a front panel 2, cell string 3, a back panel 4 and a mirror 5.

The front panel 2 is made of a glass or a synthetic resin that transmits sunlight. The front panel 2 constitutes an outermost side substrate in an incident direction of the sunlight. The front panel 2 is 150mm high, 150mm long and 2mm thick. The glass from which the front panel is made may be a white glass, a heat resistance glass, a hardened glass, a tempered glass, a heat reflecting glass or the like, for example. The synthetic resin may be polycarbonate or the like, for example.

The cell string 3 includes plural cells 3a that are made of poly crystal silicon or crystal silicon and are used for photovoltaic generation. The cells 3a are arranged in the lateral direction at an even interval P as shown in Fig. 1. The interval P is 30mm. Each cell 3a is disposed in parallel with each other at almost an even interval. Herein, three cells 3a are connected in series. More specifically, copper interconnectors that have a 2mm width and coated by nickel are connected to the cells 3a using a lead-free soldering material such as tin silver copper alloy. Then the three cells 3a connected in series and output terminals that are connected to both ends of the three cells 3a are sandwiched by the glass or the synthetic resin from above and from underneath. Thus the cell string 3 is flatpacked. The cell 3a constitutes a photovoltaic generation part.

Each of the cells 3a includes a p-type silicon wafer substrate and n+/p/p+ conjunction structure. Herein, the n-layer is formed by diffusing phosphorus, and the p-layer is formed by diffusing boron. Bifaciality of the cell 3a is 0.85. The bifaciality indicates a ratio of the generation efficiency of the front side and generation efficiency of the back side of the cell 3a. The cell 3a is 150mm high, 125mm long and $200\mu$m thick. The cell 3a is a bifacial type having an efficiency of 15.0%. The cell 3a includes an optical thin film on the surface of the cell 3a. An antireflection finish and texturing finish are made on the optical thin film. The cell 3a has a structure which reduces loss of generation which is caused by reflection of sunlight on the surface of the cell 3a.

A film type resin seal is provided between the cell string 3 and the front panel 2 and between the cell string 3 and the back panel 4. The resin seal constitutes a seal member. The resin seal is made of EVA (Ethylene Vinyl Acetate Copolymer), for example. The resin seal suppresses development of a void between the cell string 3 and the front panel 2 and between the cell string 3 and the back panel 4. The resin seal is bridged and hardened between the cell string 3, the front panel 2 and the back panel 4 under a predetermined pressure and at a predetermined temperature. Thus the resin seal holds and joins the cell string 3, the front panel 2 and the back panel 4 strongly together. Herein, EVA does not require an intermediate material such as adhesive material. Alternatively the resin seal which holds and joins the cell string 3, the front panel 2 and the back panel 4 may be held by using adhesive material.

The back panel 4 can transmit the sunlight and can be attached with the mirror 5, which has a bellows-like wave surface, on the back. The back panel 4 is 150mm high, 150mm long and 10mm thick. The back panel 4 is formed by grinding a back surface of a heat resistance glass. The grinding process is realized by end mill treatment in which a diamond cutting tool is used. The back surface of the heat resistance glass is grinded so that surface roughness Rz thereof becomes 0.5μm. Then the back panel 4 which has optical elements corresponding to the cells 3a is formed.

The mirror 5 constitutes a reflector which has the bellows-like wave surface. The mirror 5 is made by depositing a reflective film having a 120nm thick on the back surface by a sputtering process, and by coating an acrylate resin paint in order to form an overcoat layer on the back surface of the reflection film. The mirror 5 has the bellows-like wave surface and has a function of reflecting the sunlight which enters from the front panel 2 and collecting the sunlight onto the cells 3a of the cell string 3.

The cells 3a of the cell string 3 converts the sunlight which enters from the front panel 2 and is reflected and collected by the mirror 5 into electricity, and outputs a predetermined voltage to the output terminals.

The cell string 3 and the back panel 4 are disposed so that the center line A and a portion at which the thickness of the back panel 4 in the front direction becomes the thinnest correspond to each other. The center line A is located between the two cells 3a that are adjacent to each other in an array direction. The back panel 4 on which the mirror 5 is formed, a seal member, the cell string 3, a seal member and the front panel 2 are stacked in this order and are dried and laminated under vacuum by a diaphragm type vacuum dry laminator in a hot press condition of 135 °C and 15 minutes. The solar cell 1 is formed in the condition as described above.

As shown in Fig. 1, the mirror 5 has a peak portion on the midline A which is located between the two cells 3a that are adjacent to each other in an array direction, and a peak portion on a centerline B which is located in the center of the cell 3a. The mirror 5 has a valley portion in the intermediate point between the midline A and the centerline B. The distance between the midline A and the centerline B in the array direction is a half length of the pitch P. The distance between the peak portion corresponding to the midline A and the valley portion in the array direction, which constitutes the midline-peak-valley-pitch, is a quarter length of the pitch P. The distance between the valley portion and the peak portion corresponding to the centerline B in the array direction, which constitutes the centerline-peak-valley-pitch, is a quarter length of the pitch P.

The mirror 5 includes the peak portions and the valley portions as viewed from the direction vertical to the front direction and the array direction of the cells 3a. The peak portions and the valley portions have a cycle of a half pitch P/2. Thus, the surface of the mirror 5 constitutes the bellows-like wave surface.

Further, the positions of the peak portions of the mirror 5 in the array direction correspond to the positions of the centerlines B of the cells 3a in the array direction and the midlines A between the cells 3a next to each other in the array direction. Further, first R machined portion 5a are formed at the peak portions that correspond to the midlines A. A first radius R1 of the first R machined portion 5a is more than 0.05mm and is smaller than P/5 which corresponds to one-fifth of the pitch P. Herein, the first radius R1 is set to 0.8mm. Channel portions of the first R machined portion 5a which correspond to the back panel 4 are formed by a milling process using R bit tool.

The solar cell 1 according to the first embodiment can suppress multiple scattering of the sunlight at the peak portions located on the midlines A, in a case where the sunlight enters the portions close to the peak portions that are located on the midlines A among the peak portions that constitute rounded portions of the mirror 5. The reason why this is achieved is that the peak portions include the first R machined portion 5a, and that the first radius R1 of the first R machined portion 5a is more than 0.05mm and smaller than P/5 which corresponds to one-fifth of the pitch P. Hereinafter, effects that suppress the multiple scattering will be described with reference to the drawings. Fig. 2 shows a pattern diagram of a solar cell according to one embodiment of the present invention. Fig. 3 shows a pattern diagram of conventional solar cell.

When the sunlight enters the solar cell 1, transmits through the front panel 2 and reaches the peak portions of the mirror 5 which is located on the midline A, the sunlight is reflected widely by the peak portions by a diffractive effect in a case where the peak portions do not have the first R machined portion 5a and are formed in sharp angled shape. Thus, as shown in Fig. 2, the first R machined portion 5a having the first radius R1 as described above are formed at the peak portions located on the midline A, so that diffraction at around the peak portions is reduced. As a result, multiple scattering of reflected lights L2, L3 and L4 in a wide range with regard to an incident light L1 is suppressed. Thus, detraction of an exterior appearance for a person which is caused by the glare of bright lines in a striped shape configuration of the solar cell 1 is suppressed. Accordingly, merchantability of a house or a vehicle on which the solar cell 1 is mounted is improved.

According to the conventional solar cell, as shown in Fig. 3, the cells 3a are disposed so that the centerlines B and the valley portions correspond to each other. In a case where the sunlight enters planes that are formed between the peak portions and valley portions of the mirror 5 in the array direction at a shallow angle, the sunlight which is reflected by the mirror 5 is not collected onto the back surface of the cell 3a, according to the conventional solar cell as shown in Fig. 3. Thus, the incident light is reflected by two reflective surfaces that are located between the peak portions and the valley portion and that constitute a V-like shape. The incident light transmits the front panel 2 which is located in a position where the cell 3a is not located as viewed from the front side. Thus, light loss occurs. The solar cell 1 according to the first embodiment can suppress the occurrence of light loss as described above. The solar cell 1 according to the first embodiment can improve light collection performance and power generation efficiency in a case where the sunlight enters the solar cell 1 at a shallow angle.

Since the first R machined portion has the radius R as described above, the light loss which is caused by the incident light which does not enter the cell and leaks from a module as shown in Fig. 12 is suppressed. Further, light loss which is caused by the incident light which does not satisfy a total reflection condition and leaks from the module as shown in Fig. 13 is suppressed.

The solar cell 1 according to the first embodiment is a bifacial solar cell with an enhanced bifaciality. The peak portions of the mirror 5 are located on the back of the cells 3a in the array direction and on the centerlines B. Thus, the portions at which the thicknesses of the back panel 4 in the front direction become the thinnest are located on the centerlines B. When a person sees the solar cell 1, the solar cell 1 can show him/her a black exterior appearance which is provided by a reflection of the back surface of the cells 3a through the mirror 5. Thus, a glare of the solar cell 1 is suppressed, and the exterior appearance of the solar cell 1 is improved and has a premium look.

As described above, the first radius R1 of the first R machined portion 5a is more than 0.05mm and smaller than P/5 which corresponds to one-fifth of the pitch P. It is preferable that the first radius R1 of the first R machined portion 5a is more than 0.10mm and smaller than P/8. Further, it is preferable that the first radius R1 of the first R machined portion 5a is more than 0.15mm and smaller than P/15. It is possible to improve machining performance of the first R machined portion 5a onto the mirror 5 which includes the bellows-like wave surface.

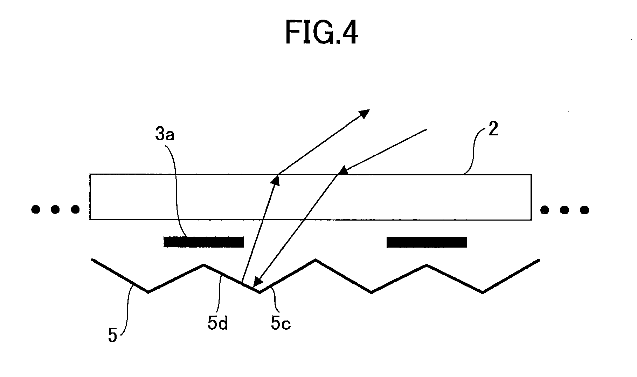

As described above, the midline-peak-valley-pitch between the peak portion which is located on the midline A and the valley portion, and the centerline-peak-valley-pitch between the peak portion which is located on the centerline B and the valley portion are equal to the length of P/4. The solar cell 1 according to the first embodiment still has a problem as described below. Hereinafter, the problem will be described with reference to Fig. 4. Fig. 4 shows pattern diagram of a solar cell according to one embodiment of the present invention.

As shown in Fig. 4, in a condition where the peak portions are located on the centerlines B of the cells 3a, if sunlight enters a reflective surface, which faces upper right and is located between the peak portion and the valley portion that is located next to the peak portion on the right side, a problem as described below occurs. More specifically, as shown in Fig. 4, if incident light flux (sunlight) transmits through the front panel 2 and the back panel 4 at a shallow angle, the problem as described below occurs. Since the reflective surfaces face upper right or upper left and extend beyond both edges of the cells 3a from the centerline B, a reflected light flux is not guided onto the back surfaces of the cells 3a, but is transmitted to the back panel 4 and the front panel 2. Then the reflected light flux leaks from the solar cell 1. Thus, light loss occurs. Thus, it becomes possible to reduce the light loss and improve the light collection performance by modifying the dimensions of the midline-peak-valley-pitch and the centerline-peak-valley-pitch. Hereinafter, the second embodiment thereof will be described.

[Second Embodiment]

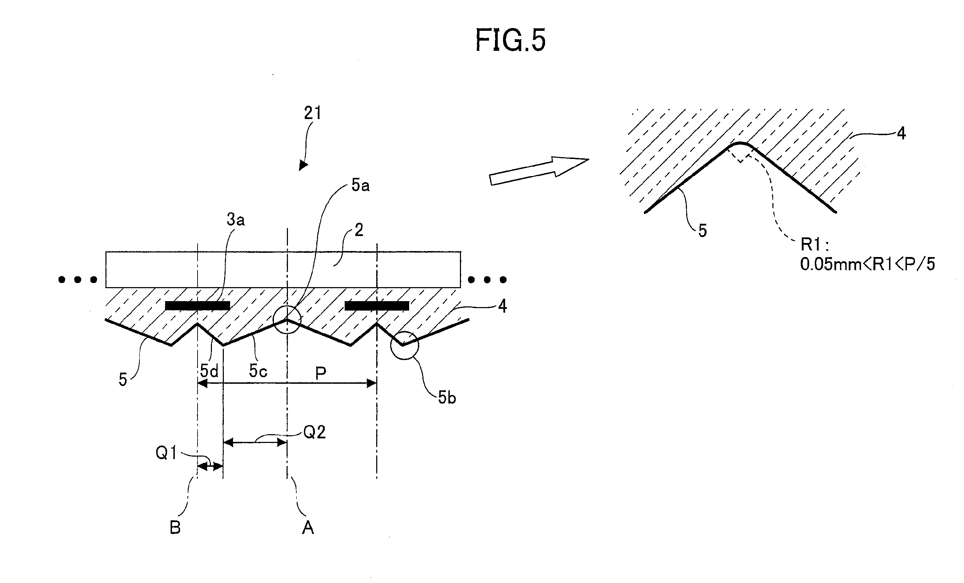

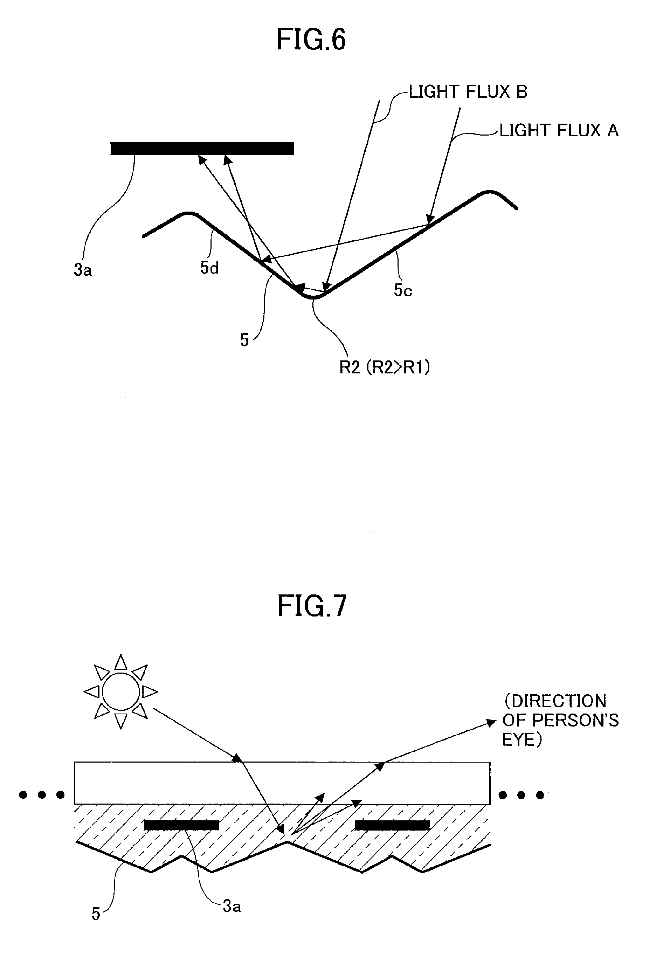

Fig. 5 shows a pattern diagram of a solar cell according to one embodiment of the present invention. Fig. 6 shows pattern diagram of a solar cell according to one embodiment of the present invention. Fig. 7 shows a function effect of the solar cell according to one embodiment of the present invention. Fig. 8 shows a function effect of the solar cell according to one embodiment of the present invention.

A solar cell (module) 21 as shown in Fig. 5 includes the front panel 2, the cell string 3, the back panel 4 and the mirror 5. Since basic configurations of each elements are similar to those as shown in the first embodiment, duplicate description thereof may be omitted, and differences thereof will be described in detail.

As shown in Fig. 5, peak portions that are formed by the mirror 5 are located so that the peak portions correspond to midlines A of the cells 3a that are adjacent to each other in the array direction and centerlines B of the cells 3a in the array direction. Valley portions are arranged between the peak portions that are adjacent to each other. The centerline-peak-valley-pitch Q1 between the peak portion which is located on the centerline B and the valley portion is smaller than the midline-peak-valley-pitch Q2 between the peak portion which is located on the midline A and the valley portion. The centerline-peak-valley-pitch Q1 is 5.0mm, and the midline-peak-valley-pitch Q2 is 10.0mm. Thus, the valley portions are decentered from a midpoint between the midlines A and the centerlines B so that the valley portions are located closer to the centerlines B than to the midlines A.

Further, as shown in Fig. 5, the valley portions formed by the mirror 5 include a second R machined portions 5b. Second radius R2 of the second R machined portions 5b is larger than the first radius R1 of the first R machined portion 5a. The second radius R2 is 1.7mm, and the first radius R1 is 1.0mm.

As described above, the solar cell 21 according to the second embodiment can suppress multiple scattering of sunlight at the peak portions in a manner similar to the first embodiment as shown in Fig. 7. As shown in Fig. 8, the solar cell 21 according to the second embodiment can suppress the bright lines in a striped shape configuration. In addition to these, the solar cell 21 can provide functional effects as described below. That is, it becomes possible to suppress multiple scattering at the valley portions in a case where the incident sunlight reaches into the valley portions that include the second R machined portions 5b. The second R machined portions 5b are formed by the second radius R2 which is larger than the first radius R1. Further, it becomes possible to transform directions of the reflected sunlight to the back surface of the cells 3a, effectively.

As shown in Fig. 4, the mirror 5 according to the first embodiment includes a second reflective surface 5d. The second reflective surface 5d that is formed between the peak portions located on the centerlines B of the cells 3a and the valley portions next to the peak portions constitute reflective surface that faces upper right or upper left. The second reflective surface 5d extends beyond both edges of the cells 3a from the centerlines B. In a case where the sunlight enters the solar cell 1 at a shallow angle and is reflected by the mirror 5, the sunlight is not guided onto the back surfaces of the cells 3a, but is transmitted to the back panel 4 and the front panel 2 and leaks from the solar cell 1. According to the second embodiment, the both edges of the second reflective surface 5d are located closer to the centerlines B by defining that the centerline-peak-valley-pitch Q1 is smaller than the midline-peak-valley-pitch Q2. Thus, it becomes possible to effectively guide the sunlight which enters at a shallow angle, as shown in Fig. 4, to the back surface of the cell 3a as indicated by a light flux B as shown in Fig. 6.

In addition, it becomes possible to make an angle between a first reflective surface 5c and an array direction smaller than an angle between a first reflective surface 5c and an array direction as shown in Fig. 4. Thus, it becomes possible to guide a light flux A which enters the first reflective surface 5c next to the midline A as shown in Fig. 6 to the reflective surface next to the centerline B, and to cause the second reflective surface 5d next to the centerline B to reflect the light flux A. Accordingly, it becomes possible to guide the light flux A to the back surface of the cell 3a by a double reflection configuration.

It becomes possible to improve the exterior appearance of the solar cell 21 and to provide a premium look by suppressing the glare which may be felt by a person who sees the solar cell 21 in a case where the solar cell 21 is viewed from an angle.

According to the solar cell 21 of the second embodiment, it becomes possible to collect the sunlight effectively on the back surface of the cell 3a when the sunlight enters the solar cell 21 at a shallow angle in the morning, at nightfall or in winter. Thus, it becomes possible to keep the enhanced light collection performance and enhanced power generation efficiency through out the day and during each of the four seasons. Further, it becomes possible to enhance energy efficiency by improving an integral intensity of temporal transitional and seasonal transitional electric generating capacity.

According to the solar cell 21 of the second embodiment, it becomes possible to suppress multiple scattering of sunlight at the peak portions in a case where the pitch P, which is a gap between the cells 3a, is increased more than the pitch P of the first embodiment. Thus, it becomes possible to suppress a leakage of sunlight which is caused in a condition where the sunlight is reflected at the valley portions or the second reflective surface 5d and is not guided onto the back surface of the cell 3a. Accordingly, the light loss is suppressed, and a scale factor of light collection and a light collection performance are improved. A ratio of profile areas of the cells 3a to a profile area of the solar cell 21 as viewed from the front side is reduced. Thus, it becomes possible to reduce the cost of the solar cell 21.

According to the second embodiment, as described above, a inclined angle of the first reflective surface 5c next to the midline A to the array direction is not defined. The inclined angle may be defined. Hereinafter, a third embodiment thereof will be described.

[Third Embodiment]

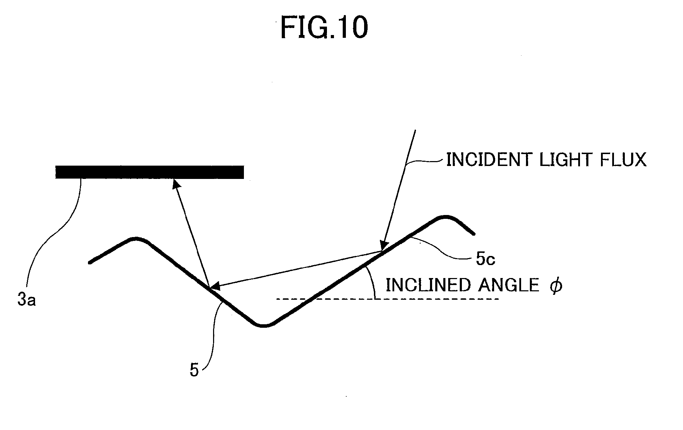

Fig. 9 shows a pattern diagram of a solar cell according to one embodiment of the present invention. Fig. 10 shows another pattern diagram of a solar cell according to one embodiment of the present invention.

A solar cell (module) 31 as shown in Fig. 9 includes the front panel 2, the cell string 3, the back panel 4 and the mirror 5. Since basic configurations of each elements are similar to those as shown in the second embodiment, duplicate description thereof may be omitted, and differences thereof will be described in detail.

As shown in Fig. 9, the mirror 5 has a total light reflectivity r at a wavelength of 550nm of sunlight, cell width x of the cell 3a in the array direction, a scale factor of light collection a and thickness t from the front surface of the front panel to the peak portion of the mirror 5. The scale factor of light collection a is derived by dividing the pitch P by the cell width x, i.e. a=P/x. Further, as shown in Fig. 10, an inclined angle between the first reflective surface 5c next to the midline A of the mirror 5 and the array direction which is shown by a dotted line is defined as $\varphi$. The inclined angle $\varphi$ is indicated as an angle $\theta$, and the angle $\theta$ is defined by a designated formula Q which is shown as a formula 6.

[formula 6]

$$\Omega(\theta) = \frac{1-r}{a} + \frac{r}{P} \cdot \frac{a \cdot t \cdot \tan 2\theta + a \cdot P \cdot \tan 2\theta \cdot \sin \theta + P}{a \cdot (1 + \tan 2\theta \cdot \tan \theta)}$$

The designated formula Q which is defined as formula 6 has a maximum value Ωmax which is given as a convexed inflection point when the angle θ ranges between 0 to 90 degrees. The inclined angle φ is defined as shown in formula 7 by using the angle θ=φmax which gives the maximum value Ωmax.

[formula 7]

$$\Phi max - 15° \leqq \Phi \leqq \Phi max + 15°$$
$$(\text{PREFERABLE} \qquad \Phi max - 10° \leqq \Phi \leqq \Phi max + 10°$$
$$\text{MORE PREFERABLE} \quad \Phi max - 7° \leqq \Phi \leqq \Phi max + 7° \quad )$$

The inclined angle φ is set to a value which is greater than a value derived by subtracting 15 degrees from the inclined angle φmax, and which is less than a value derived by adding 15 degrees to the inclined angle φmax. Herein, it is preferable to subtract or add 10 degrees instead of 15 degrees. Further, it is more preferable to subtract or add 7 degrees instead of 15 degrees. It is practical to calculate the inclined angle φmax by using a Taylor series of expansion which includes more than a fourth degree of the angle θ contained in the formula Ω(θ),and by using θ differentiation. Thus, the calculated load is reduced.

According to the solar cell 31 of the third embodiment, functional effects as described below are obtained in addition to functional effects similar to those described in the second embodiment. Sunlight reflected by the mirror 5 is guided uniformly onto the back surface of the cell 3a. Thus, unevenness in the strength of the sunlight on the back surface is reduced when the sunlight is exposed onto the back surface of the cell 3a. Thus, it becomes possible to suppress a decrease in power generation efficiency, which is caused by the unevenness in the strength of the sunlight, of the cells 3a and the solar cell 31 itself in advance.

Further, it becomes possible to efficiently utilize the total internal reflection light which is reflected under Snell's law at the surface of the front panel 2. The leakage of sunlight which is caused in a condition where sunlight is not collected onto the back surface of the cell 3a is suppressed regardless of directions in that the solar cell 31 is mounted on a roof of a house, vehicle, etc. Thus, it becomes possible to keep the enhanced power generation efficiency through a year.

Further, since the solar cell 31 can reduce the unevenness in the strength of the sunlight on the back surface of the cell 3a, it becomes possible to suppress heat deterioration of the resin seal 4 which is caused by enhanced light collection.

Accordingly, it becomes possible to suppress the occurrence of the problems in the solar cell 31 by suppressing the occurrence of peel-off of the resin seal from the cells 3a and crack therebetween. Thus, the life duration of the module which constitutes the solar cell 31 is not shortened as compared to the conventional solar cell in which light collection as described above is not realized. The solar cell 31 can realize the light collection advantageously.

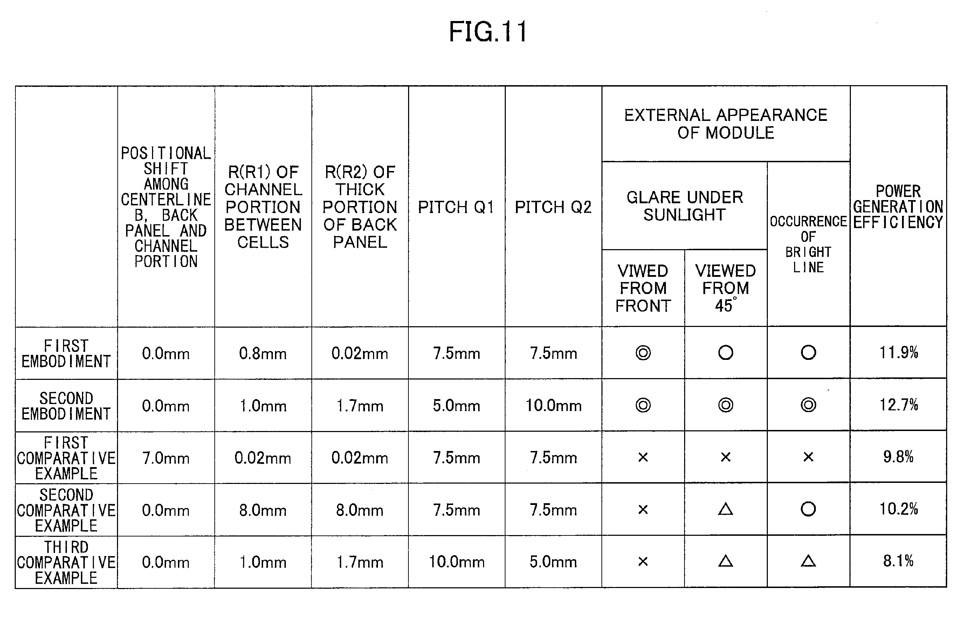

Fig. 11 shows a table which includes the results of external appearances of modules that constitute solar cells and power generation efficiencies. The modules as shown in the table include the solar cells of the first and second embodiments and first to third comparative examples. The results of the external appearances are obtained as viewed from the front side and from an angle. The power generation efficiencies are measured by using a solar simulator where the solar cells have an effective generating area of 90mm x 125mm.

The solar cells according to the first to third comparative examples have specifications as described below. The solar cell according to the first comparative example includes cell string 3 which is the same as the cell string 3 according to the first embodiment. According to the first comparative example, locations of the peak portions of the cell string 3 are shifted by 7mm from the centerlines B of the cells 3a in the array direction.

The solar cell according to the second comparative example includes a cell string 3 which is the same as the cell string 3 according to the first embodiment. According to the second comparative example, the first radius R1 of the first R machined portion 5a is 8.0mm which exceeds 6mm that corresponds to one-fifth of the pitch P=30mm. Further the second R machined portions 5b that have the second radius R2 are formed at the valley portions. The second radius R2 is 8mm. Thus, the condition of R2>R1 is not satisfied according to the second comparative example.

The solar cell according to the third comparative example includes a cell string 3 which is the same as the cell string 3 according to the second embodiment. According to the third comparative example, portions at which the thickness of the back panel 4 become the thinnest are not located on the centerlines B, but are shifted closer to the midlines A that are located between the cells 3a next to each other. The centerline-peak-valley-pitch Q1 is 10.0mm, and the midline-peak-valley-pitch Q2 is 5.0mm. Thus, the condition that the centerline-peak-valley-pitch Q1 is smaller than midline-peak-valley-pitch Q2 is not satisfied according to the third comparative example.

As shown in the table of Fig. 11, the solar cells of the first and second embodiments show highly enhanced results of external appearances as viewed from the front side compared with the first to third comparative examples.

The solar cells of the first and second embodiments show relatively enhanced results of external appearances as viewed from 45 degrees compared with the first to third comparative examples. Particularly, the table shows that the second embodiment produces great improvement in suppressing the glare under sunlight. The solar cells of the first and second embodiments can suppress the bright lines in a striped shape configuration compared with the first to third comparative examples. Particularly, the table shows that the second embodiment produces great improvement in suppressing the bright lines in a striped shape configuration.

The solar cells of the first and second embodiments can realize enhanced power generation efficiencies that are measured by the solar simulator compared with the first to third comparative examples. Particularly, the table shows that the second embodiment produces great improvement in power generation efficiency.

Although, the preferred embodiments and the variations thereof are described in detail, the present invention is not limited to these embodiments, but variations and modifications may be made without departing from the scope of the present invention.

For example, as described above, the pitches P are formed only in the lateral direction, and the sunlight is collected in the one dimension. Pitches may be formed in the longitudinal direction, i.e. in the direction of a normal line shown in Fig. 1, in addition to the lateral direction, and the sunlight may be collected in the two dimensions.

[Industrial Applicability]

The present invention relates to a solar cell, and provides a solar cell which can reflect sunlight properly by making positional changes around a reflector. The present invention can improve power generation efficiency of a solar cell, and can improve merchantability of a house or a vehicle on which the solar cell is mounted. Thus, the present invention provides benefits if the present invention is applied to solar cells that are widely used in various industrial fields.

The present application is based on Japanese Priority Application No. 2009-013508 filed on January 23, 2009 with the Japanese Patent Office, the entire contents of which are hereby incorporated by reference.

## EXPLANATION FOR REFERENCE NUMERALS

| | |
|---|---|
| 1 | solar cell (module) |
| 2 | front panel |
| 3 | cell string |
| 3a | cell (photovoltaic generating part) |
| 4 | back panel |
| 5 | mirror (reflecting plate, 4+5: reflecting part) |
| 5a | first R machined portion |
| 21 | solar cell (module) |
| 5b | second R machined portion |
| 31 | solar cell (module) |

## Claims

1.  A solar cell comprising:

    a front panel;
    photovoltaic generating parts configured to be located on a back side of the front panel and to be arranged in an array direction at a designated pitch; and
    a reflective part configured to reflect sunlight toward the back surface of the photovoltaic generating parts,
    wherein the reflective part includes a reflective panel and a back panel,
    wherein the reflective panel includes peak portions projecting into a front direction of the photovoltaic generating parts and being arranged at a cycle of a half pitch of the designated pitch, and valley portions concaving into a back side of the photovoltaic generating parts as viewed from a vertical direction vertical to the front direction and the array direction,
    wherein positions of centerlines of the photovoltaic generating parts in the array direction and positions of midlines between the photovoltaic generating parts next to each other in the array direction correspond to positions of the peak portions in the array direction, and
    wherein a first R machined portion is formed at the peak portion corresponding to the midline, and a first radius which constitutes the first R machined portion is greater than 0.05mm and smaller than one-fifth of the designated pitch.

2. The solar cell according to claim 1, wherein a midline-peak-valley-pitch between the peak portion corresponding to the midline and the valley portion next to the peak portion in the array direction is larger than a centerline-peak-valley-pitch between the peak portion corresponding to the centerline and the valley portion next to the peak portion in the array direction.

3. The solar cell according to claim 1, wherein a second R machined portion is formed at the valley portion next to the peak portion corresponding to the centerline, and wherein a second radius which constitutes the second R machined portion is larger than the first radius.

4. The solar cell according to any one of claims 1 to 3,
   wherein a designated formula is defined by the pitch, an inclined angle between the reflective panel and the array direction as viewed from the vertical direction, a thickness between a front surface of the front panel and the peak portion of the reflective panel corresponding to the midline in the front direction, a scale factor of light collection derived by dividing the pitch by a width of the photovoltaic generating part in the array direction and a total light reflectivity of the reflective panel,
   wherein a lower limit of the inclined angle is derived by subtracting 15 degrees from the inclined angle corresponding to a maximum value of the designated formula when the inclined angle ranges between 0 to 90 degrees, and an upper limit of the inclined angle is derived by adding 15 degrees to the inclined angle corresponding to the maximum value of the designated formula, and
   wherein the inclined angle is greater than the lower limit and is smaller than the upper limit.

# FIG.1

R1 :
$0.05mm < R1 < P/5$

EP 2 383 798 A1

# FIG.2

# FIG.3

# FIG.4

# FIG.5

R1 :
0.05mm<R1<P/5

EP 2 383 798 A1

# FIG.6

LIGHT FLUX B

LIGHT FLUX A

3a

5d

5

5c

R2 (R2>R1)

# FIG.7

(DIRECTION OF PERSON'S EYE)

5

3a

# FIG.8

BRIGHT LINE IN
STRIPED SHAPE
CONFIGURATION

3a

# FIG.9

31

A

x

t

P (a=P/x)

B          B

5

5
(TOTAL LIGHT
REFLECTIVITY:
r AT 550 nm)

3a(3)

# FIG.10

INCIDENT LIGHT FLUX

5c

INCLINED ANGLE $\phi$

3a

5

# FIG.11

| | POSITIONAL SHIFT AMONG CENTERLINE B, BACK PANEL AND CHANNEL PORTION | R(R1) OF CHANNEL PORTION BETWEEN CELLS | R(R2) OF THICK PORTION OF BACK PANEL | PITCH Q1 | PITCH Q2 | EXTERNAL APPEARANCE OF MODULE | | | POWER GENERATION EFFICIENCY |
| | | | | | | GLARE UNDER SUNLIGHT | | OCCURRENCE OF BRIGHT LINE | |
| | | | | | | VIWED FROM FRONT | VIEWED FROM 45° | | |
| FIRST EMBODIMENT | 0.0mm | 0.8mm | 0.02mm | 7.5mm | 7.5mm | ◎ | ○ | ○ | 11.9% |
| SECOND EMBODIMENT | 0.0mm | 1.0mm | 1.7mm | 5.0mm | 10.0mm | ◎ | ◎ | ◎ | 12.7% |
| FIRST COMPARATIVE EXAMPLE | 7.0mm | 0.02mm | 0.02mm | 7.5mm | 7.5mm | × | × | × | 9.8% |
| SECOND COMPARATIVE EXAMPLE | 0.0mm | 8.0mm | 8.0mm | 7.5mm | 7.5mm | × | △ | ○ | 10.2% |
| THIRD COMPARATIVE EXAMPLE | 0.0mm | 1.0mm | 1.7mm | 10.0mm | 5.0mm | × | △ | △ | 8.1% |

EP 2 383 798 A1

# FIG.12

(DIRECTION IN WHICH BRIGHT LINE IS DETECTED)

REFLECTIVE PANEL

BIFACIAL TYPE SOLAR CELL

EP 2 383 798 A1

# FIG.13

(DIRECTION IN
WHICH BRIGHT
LINE IS DETECTED)

REFLECTIVE
PANEL

BIFACIAL TYPE
SOLAR CELL

## INTERNATIONAL SEARCH REPORT

| | International application No. |
|---|---|
| | PCT/JP2010/050484 |

A. CLASSIFICATION OF SUBJECT MATTER
*H01L31/052*(2006.01)i, *H01L31/042*(2006.01)i

According to International Patent Classification (IPC) or to both national classification and IPC

B. FIELDS SEARCHED

Minimum documentation searched (classification system followed by classification symbols)
H01L31/052, H01L31/042

Documentation searched other than minimum documentation to the extent that such documents are included in the fields searched
Jitsuyo Shinan Koho          1922-1996   Jitsuyo Shinan Toroku Koho   1996-2010
Kokai Jitsuyo Shinan Koho    1971-2010   Toroku Jitsuyo Shinan Koho   1994-2010

Electronic data base consulted during the international search (name of data base and, where practicable, search terms used)
JSTPlus/JMEDPlus/JST7580(JDreamII), CiNii

C. DOCUMENTS CONSIDERED TO BE RELEVANT

| Category* | Citation of document, with indication, where appropriate, of the relevant passages | Relevant to claim No. |
|---|---|---|
| A | JP 11-307791 A (Sanyo Electric Co., Ltd.), 05 November 1999 (05.11.1999), entire text; all drawings (Family: none) | 1-4 |
| A | WO 1989/005520 A1 (FRAUNHOFER), 15 June 1989 (15.06.1989), fig. 1, 2 & EP 0347443 A1        & DE 3741485 A | 1-4 |
| A | WO 2005/074039 A1 (Kyocera Corp.), 11 August 2005 (11.08.2005), fig. 2 & JP 4213718 B        & US 2008/0283115 A1 | 1-4 |

☒ Further documents are listed in the continuation of Box C.      ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 28 January, 2010 (28.01.10) | 09 February, 2010 (09.02.10) |

| Name and mailing address of the ISA/ Japanese Patent Office | Authorized officer |
|---|---|
| Facsimile No. | Telephone No. |

Form PCT/ISA/210 (second sheet) (April 2007)

**INTERNATIONAL SEARCH REPORT**

International application No.

PCT/JP2010/050484

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2006-344964 A  (General Electric Co.),<br>21 December 2006 (21.12.2006),<br>fig. 4<br>& US 2006/0272698 A1    & EP 1732141 A1<br>& CN 1877865 A | 1-4 |
| A | JP 2001-119054 A  (Hitachi, Ltd.),<br>27 April 2001 (27.04.2001),<br>fig. 1<br>(Family: none) | 1-4 |
| A | WO 1998/031054 A1  (Hitachi, Ltd.),<br>16 July 1998 (16.07.1998),<br>fig. 1<br>(Family: none) | 1-4 |
| A | JP 2001-210847 A  (Hitachi, Ltd.),<br>03 August 2001 (03.08.2001),<br>fig. 1(B)<br>(Family: none) | 1-4 |
| A | JP 60-128678 A  (Fuji Electric Corporation<br>Research and Development Ltd.),<br>09 July 1985 (09.07.1985),<br>fig. 2, 3<br>(Family: none) | 1-4 |
| A | JP 11-243225 A  (Hitachi, Ltd.),<br>07 September 1999 (07.09.1999),<br>entire text; all drawings<br>& US 2001/0008144 A1    & DE 19907506 A<br>& AU 1731299 A          & AU 728400 B<br>& CN 1227419 A | 1-4 |
| A | JP 2001-007371 A  (Nippon Telegraph And<br>Telephone Corp.),<br>12 January 2001 (12.01.2001),<br>paragraphs [0047] to [0048]; fig. 17, 19<br>(Family: none) | 1-4 |
| A | WO 2008/099542 A1  (Omron Corp.),<br>21 August 2008 (21.08.2008),<br>paragraphs [0091] to [0092]; fig. 28, 29<br>& JP 2008-198460 A | 1-4 |

Form PCT/ISA/210 (continuation of second sheet) (April 2007)

**EP 2 383 798 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2001119054 A
- JP H11307791 B
- JP H11074552 B
- JP 2009013508 A